# EUROPEAN PATENT SPECIFICATION

(11) **EP 2 509 220 B1**
(45) Date of publication and mention of the grant of the patent: **12.10.2016**
(21) Application number: 11161581.1
(22) Date of filing: 07.04.2011
(51) Int. Cl.: H03G 3/32, H04B 1/10, H04B 1/40, H04B 15/02, H04B 1/00, H04W 88/06, H03G 3/30

(54) **Method and system for adjusting wlan radio receiver gain in a wireless device**
Verfahren und System zur Anpassung einer WLAN-Funkempfängerverstärkung in einer drahtlosen Vorrichtung
Procédé et système pour le réglage d'un gain de récepteur radio WLAN dans un dispositif sans fil

(43) Date of publication of application: 10.10.2012
(73) Proprietor: BlackBerry Limited, Waterloo, ON N2K 0A7 (CA)
(72) Inventor: Smadi, Mohammed Nawaf, Waterloo Ontario N2L 3W8 (CA); Kezys, Vytautas Robertas, Waterloo Ontario N2L 3W8 (CA)
(74) Representative: Moore, Barry

(56) References cited:
- WO-A1-01/06669
- WO-A1-2010/014806
- US-A- 5 722 061
- US-A1- 2003 181 180
- US-A1- 2009 239 471

## Description

### FIELD OF THE APPLICATION

This application relates to the field of wireless devices, and more specifically, to a method and system for adjusting receiver gain in a wireless local area network ("WLAN") radio of a wireless device supporting simultaneous WLAN and Bluetooth communications.

### BACKGROUND

Current wireless mobile communication devices include microprocessors, memory, soundcards, speakers, headphones, and run one or more software applications in addition to providing for voice communications. Examples of software applications used in these wireless devices include browsers, address books, email, instant messaging ("IM"), and mobile hotspot functions. Additionally, wireless devices have access to a plurality of services via the Internet. A wireless device may, for example, be used to browse web sites on the Internet, to transmit and receive graphics, and to execute streaming audio and/or video applications. Such wireless devices may operate on a cellular network (e.g., GSM), on a wireless local area network ("WLAN") (e.g., IEEE 802.11), on a Bluetooth network (e.g., IEEE 802.15.1), or on all of these types of networks.

One problem with current wireless devices pertains to simultaneous WLAN and Bluetooth communications. During such communications, interference may arise between WLAN signal reception and Bluetooth signal (e.g., voice) transmission. In particular, the front-end radio frequency ("RF") architectures of some wireless devices allow for simultaneous Bluetooth and WLAN operation. An example of such an architecture is one where each of the WLAN and Bluetooth radios has its own antenna. Bluetooth includes adaptive frequency hopping ("AFH") functionality which reduces co-channel interference. However, during simultaneous Bluetooth transmission ("TX") and WLAN reception ("RX"), adjacent channel interference ("ACI") continues to be a serious problem. Reducing the Bluetooth TX power level and increasing the Bluetooth to WLAN antenna isolation can help in reducing ACI but it is often not helpful enough.

One key metric of WLAN receiver performance is automatic gain control ("AGC") which is used to regulate the received signal strength at the input of the analog-to-digital converter ("ADC") within the wireless device such that the required signal-to-noise ratio ("SNR") for proper decoding is met. In the presence of strong ACI, better performance is obtained by reducing the level of AGC. This however has the effect of reducing receiver sensitivity, that is, only WLAN frames with higher SNR values will be decoded correctly. This trade-off is not present in the absence of ACI and maintaining AGC at a high value is recommended for improved WLAN receiver performance.

A need therefore exists for an improved method and system for adjusting receiver gain in a WLAN radio of a wireless device supporting simultaneous WLAN and Bluetooth communications. Accordingly, a solution that addresses, at least in part, the above and other shortcomings is desired.

WO 01/06669 A1 discloses systems and methods that can be used to maintain operation of a receiver co-located with a transmitter in a communication device and susceptible to interference therefrom by anticipating the intervals during which the transmitter is active (i.e., transmitting) and then desensitizing the receiver during that interval. Although the receiver may operate in a reduced capacity due to periodic desensitization, the adverse effects of interference generated by the transmitter can be avoided. For example, interference from the transmitter can cause variables, such as the gain applied by an automatic gain control module at the receiver input, to deviate from a normal operating or steady state value, which must then be recovered when the interference from the transmitter ceases.

US 20090239471-A1 discloses a radio frequency (RF) front-end configured to share transmissions and receptions of Bluetooth signals and WLAN signals. In an exemplary embodiment, the RF front-end comprises a first path coupled between an antenna and a transceiver dedicated to transmissions of the WLAN signals; a second path coupled between the antenna and the transceiver dedicated to simultaneous receptions of the Bluetooth signals and the WLAN signals; and a third path coupled between the antenna and the transceiver. The third path may be dedicated to transmissions only of the Bluetooth signals when a WLAN link is active; and transmissions and receptions of the Bluetooth signals when the WLAN link is active and in a power save state, and when the WLAN link is inactive.

US 5722061-A discloses a method for adjusting the gain of a receive circuit. The circuit has an LNA which amplifies the received signal. The receive signal power is controlled by enabling or disabling the LNA in response to the measured received signal power. The received power level is periodically compared to a threshold. When the received power level is greater than the threshold, the LNA is disabled. The LNA is re-enabled when the received power level is less than the threshold, and there are no significant intermodulation components detected. The intermodulation components are detected by briefly enabling the LNA and detecting the resultant change in the measured signal power. If the detected change is more than a predetermined amount, then there are significant intermodulation components present, and the LNA is not re-enabled. Otherwise, there are not significant intermodulation components present, and the LNA is re-enabled.

WO 2010014806-A1 discloses a method and apparatus for toggling between a first mode and a second mode of a receiver based on an input signal level comprising comparing a gain state of the receiver to at least one gain state thresholds; determining the presence of a jammer; and switching a current mode of the receiver to a new mode based on the presence of the jammer and the comparison of the gain state. In one aspect, the apparatus comprises two LNAs operating in different modes; a jammer detector to provide a jammer interrupt bit to indicate the presence of a jammer; and an automatic gain control (AGC) circuit coupled to the jammer detector for receiving the jammer interrupt bit, wherein the AGC circuit selects between the two LNAs based on the jammer interrupt bit and a gain state comparison.

### Summary

The present application provides a method for adjusting a gain level for a receiver as detailed in claim 1. Also provided is a system according to claim 11. Advantageous features are provided in dependent claims.

### BRIEF DESCRIPTION OF THE DRAWINGS

Features and advantages of the embodiments of the present application will become apparent from the following detailed description, taken in combination with the appended drawings, in which:
FIG. 1 is a front view illustrating a wireless device in accordance with an embodiment of the application;
FIG. 2 is a block diagram illustrating the wireless device of FIG. 1;
FIG. 3 is a block diagram illustrating a memory of the wireless device of FIG. 1;
FIG. 4 is a block diagram illustrating a short-range communications subsystem of the wireless device of FIG. 1; and,
FIG. 5 is a flow chart illustrating operations of modules within the memory of a wireless device for adjusting automatic gain control in the WLAN receiver of a wireless device during simultaneous WLAN and Bluetooth communications, in accordance with an embodiment of the application.
It will be noted that throughout the appended drawings, like features are identified by like reference numerals.

### DETAILED DESCRIPTION OF THE EMBODIMENTS

In the following description, details are set forth to provide an understanding of the application. In some instances, certain software, circuits, structures and techniques have not been described or shown in detail in order not to obscure the application. Example embodiments may be implemented in any computer programming language provided that the operating system of the device (e. g., wireless device, data processing system, etc.) provides the facilities that may support the requirements of the application. Any limitations presented would be a result of a particular type of operating system or computer programming language and would not be a limitation of the present application. Example embodiments of the present application may also be implemented in hardware or in a combination of hardware and software.

According to one embodiment of the application, there is provided a method for adjusting a gain level for a receiver of a first radio (e.g., a wireless local area network ("WLAN") radio) simultaneously operational with a transmitter of a second radio (e.g., a Bluetooth radio), the first radio and the second radio being deployed in a single wireless device, comprising: determining a signal-to-noise ratio ("SNR") value for signals (e.g., WLAN signals) received by the receiver from an access point ("AP"); and, when the first radio is associated with the AP and the transmitter is not transmitting, if the SNR value exceeds a SNR threshold, reducing the gain level for the receiver from an initial level and initiating transmission from the transmitter, otherwise maintaining the gain level for the receiver at the initial level and initiating transmission from the transmitter; wherein the SNR threshold is a SNR value above which beacon signals **(e.g.,** WLAN beacon signals) from the AP can be successfully received by the receiver.

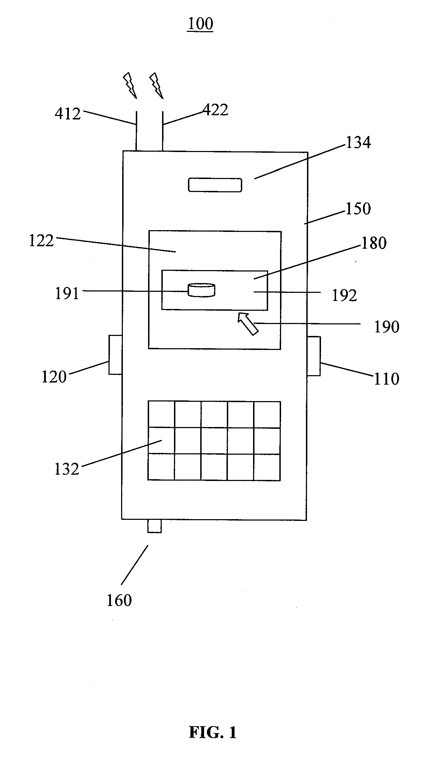

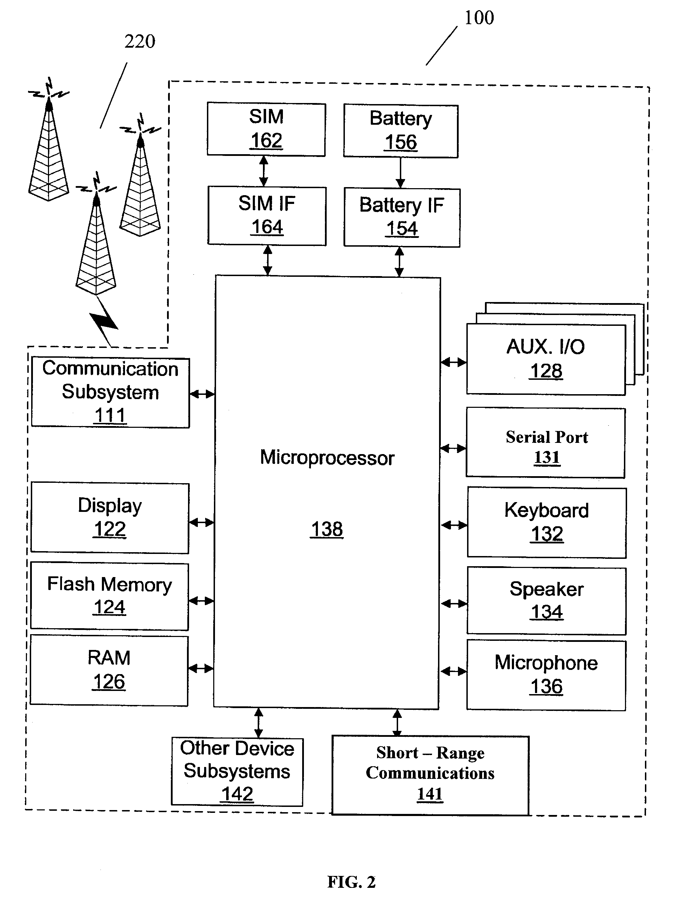

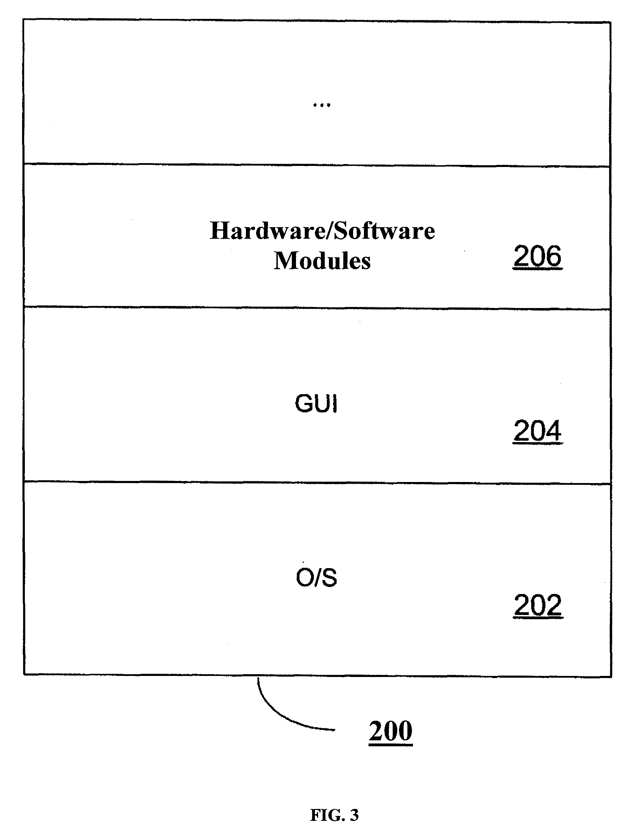

FIG. 1 is a front view illustrating a wireless device **100** in accordance with an embodiment of the application. The wireless device **100** may include a cover or case **150,** a display **(e.g.,** a liquid crystal display ("LCD")) **122,** a graphical user interface ("GUI") **180** displayed on the display **122,** a speaker **134,** a keyboard (or keypad) **132,** a trackball or thumbwheel **110,** various select buttons **120,** and various inputs/outputs **(e.g.,** power connector jack, data interface ports, headphones jack, etc.) **160.** Generally speaking and with reference also to figures 2 and 3, internally, the wireless device **100** may include a central processing unit ("CPU"), processor, or microprocessor **138,** memory **124, 126, 200,** a battery **156,** at least one antenna **412, 422,** etc., which are operatively coupled to the various inputs/outputs **160,** the keyboard **132,** the display **122,** the speaker **134,** etc., as will be described below.

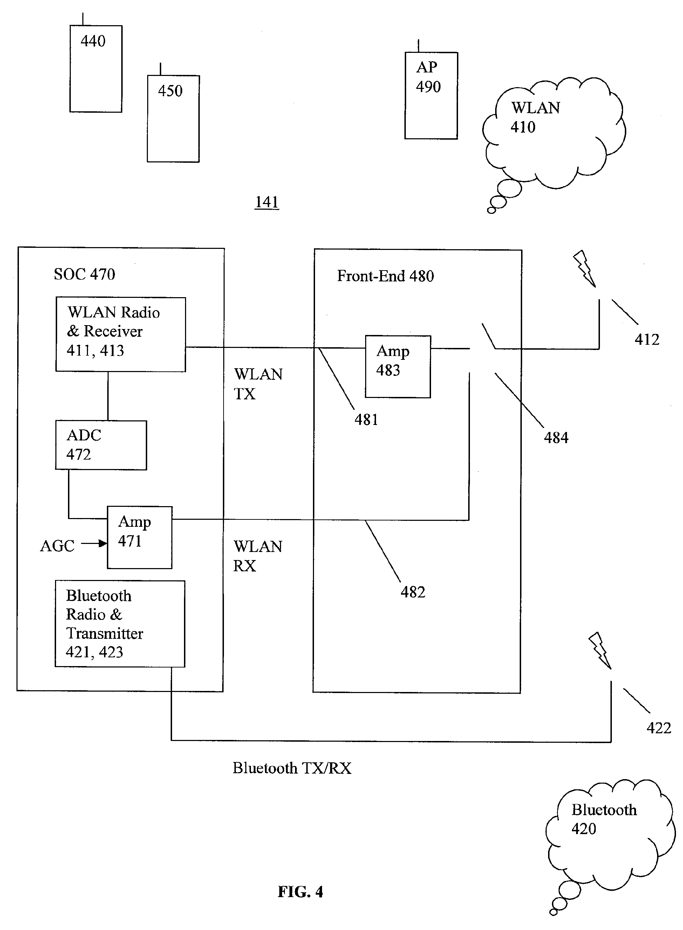

FIG. 2 is a block diagram illustrating the wireless device **100** of FIG. **1****.** The wireless device **100** may operate over a wireless network **220.** The wireless network **220** may include antennae, base stations, access points ("APs"), transceivers, supporting radio equipment **(e.g.,** a GSM radio, a Wi-Fi or WLAN radio **411,** a Bluetooth radio **421** as shown in FIG. 4, etc.), etc., as known to those of ordinary skill in the art, for supporting wireless communications between the wireless device **100** and other devices (e. g., laptop computers **440,** tablet computers **450,** etc., as shown in FIG. 4). The wireless network **220** may include a cellular network **(e.g.,** a global system for mobile communication ("GSM") network, a 3rd generation partnership project (" 3GPP") GSM network, a code division multiple access ("CDMA") network, etc.), a Wi-Fi network (i.e., a WLAN based on IEEE 802.11 standards) **410,** and a Bluetooth network (i.e., a Bluetooth network based on IEEE 802.15.1 standards) **420** as shown in FIG. 4.

The wireless device **100** may be a two-way communication device having at least voice and advanced data communication capabilities, including the capability to communicate with other devices. Depending on the functionality provided by the device **100,** it may be referred to as a data messaging device, a two-way pager, a cellular telephone with data messaging capabilities, a wireless Internet appliance, a data communication device (with or without telephony capabilities), a data processing system, a Wi-Fi device, a WLAN device, a dual-mode (i.e., Wi-Fi and cellular) device, a portable audio device, or a Bluetooth device. The device **100** may communicate with any one of a plurality of transceiver stations within its geographic coverage area.

The wireless device **100** may have a communication subsystem **111,** a subscriber identity module (or "SIM" card) **162** for inserting into a SIM interface ("IF") **164** in order to operate on a cellular network (e.g., a global system for mobile communication ("GSM") network, a 3^{rd} generation partnership project ("3GPP") GSM network, etc.), a battery IF **154** for receiving one or more rechargeable batteries **156,** a microprocessor **138** which controls overall operation of the device **100,** a flash memory **124** or other persistent store, a random access memory ("RAM") **126,** auxiliary input/output ("I/O") subsystems **128,** a serial port (e.g., a universal serial bus ("USB") port) **131,** a microphone **136,** a short-range communications subsystem **141** (e.g., for WLAN and Bluetooth communications), and other device subsystems **142.** The microprocessor **138,** in addition to performing operating system functions, preferably enables execution of software applications on the device **100.**

FIG. 3 is a block diagram illustrating a memory **200** of the wireless device **100** of FIG. 1. The microprocessor **138** is coupled to the memory **200.** The memory **200** has various hardware and software components for storing information (e.g., instructions, data, database tables, test parameters, etc.) for enabling operation of the device **100** and may include flash memory **124,** RAM **126,** ROM (e.g., **200**), disk drives (e.g., **200**), etc. In general, the memory **200** may include a variety of storage devices typically arranged in a hierarchy of storage as understood to those skilled in the art. To provide a user-friendly environment to control the operation of the device **100,** operating system ("O/S") software modules **202** resident on the device **100** may provide a basic set of operations for supporting various applications typically operable through the GUI **180** and supporting GUI software modules **204.** For example, the O/S **202** provides basic input/output system features to obtain input from the auxiliary I/O **128,** the keyboard **132,** the trackball or thumbwheel **110,** and the like, and for facilitating output to the user through the display **122,** the speaker **134,** etc. According to one example embodiment, the wireless device **100** is provided with hardware and/or software modules **206** for facilitating and implementing the method of the application as will be described below. The wireless device **100** may be provided with additional hardware and/or software modules **206** for facilitating and implementing various functions (e.g., an AGC adjustment function **206** as described below).

A user may interact with the wireless device **100** and its various modules **202, 204, 206,** using the GUI **180.** GUIs are supported by common operating systems and provide a display format which enables a user to choose commands, execute application programs, manage computer files, and perform other functions by selecting pictorial representations known as icons, or items from a menu through use of an input or pointing device such as a trackball or thumbwheel **110** and keyboard **132.** The GUI **180** may include a cursor **190,** various selectable objects and icons **191,** and various windows **192.**

Thus, the wireless device **100** includes computer executable programmed instructions for directing the device **100** to implement the example embodiments of the present application. The programmed instructions may be embodied in one or more hardware or software modules **206** which may be resident in the memory **200** of the wireless device **100** or elsewhere. Alternatively, the programmed instructions may be embodied on a computer readable medium or product (such as a CD disk or floppy disk) which may be used for transporting the programmed instructions to the memory **200** of the wireless device **100.** Alternatively, the programmed instructions may be embedded in a computer-readable signal or signal-bearing medium or product that may be uploaded to a network **220** by a vendor or supplier of the programmed instructions, and this signal or signal-bearing medium or product may be downloaded through an interface **111, 131, 141** to the wireless device **100** from the network **220** by end users or potential buyers.

FIG. 4 is a block diagram illustrating the short-range communications subsystem **141** of the wireless device **100** of FIG. 2 The short-range communications subsystem 141 includes a system-on-a-chip ("SOC") module **470** coupled to a front-end module **480.** The SOC module **470** includes a Wi-Fi or WLAN radio **411** (i.e., including a Wi-Fi or WLAN transmitter and a Wi-Fi or WLAN receiver **413**) for supporting wireless communications between the wireless device **100** and other devices (e.g., laptop computers **440,** tablet computers **450,** etc.) over a WLAN **410.** The WLAN **410** may include one or more access points ("APs") **490,** etc. The SOC module **470** also includes a Bluetooth radio **421** (i.e., including a Bluetooth transmitter **423** and a Bluetooth receiver) for supporting wireless communications between the wireless device **100** and other devices (e.g., laptop computers **440,** tablet computers **450,** etc.) over a Bluetooth network **420.** The Bluetooth radio **421** is coupled to a Bluetooth antenna **422** for transmitting and receiving Bluetooth signals. The WLAN radio **411** is coupled to a WLAN antenna **412** for transmitting and receiving WLAN signals via the front-end module **480.** The front end module **480** includes a power amplifier **483** in the WLAN TX signal path **481** for amplifying transmitted WLAN signals while the SOC module **470** includes a low noise amplifier **471** in the WLAN RX signal path **482** for amplifying received WLAN signals before they are input to the analog-to-digital converter ("ADC") **472.** According to one embodiment, the low noise amplifier **471** may be located external to the SOC module **470.** A switch **484** in the front end module **480** is used to selectively couple the TX and RX signal paths **481, 482** to the WLAN antenna **412.** The output level of the low noise amplifier **471** is adjusted to perform automatic gain control ("AGC") in accordance with the method described below to regulate the received signal strength at the input of the ADC **472.**

As mentioned above, one problem with current wireless devices pertains to simultaneous WLAN and Bluetooth communications. During such communications, interference may arise between WLAN signal RX and Bluetooth signal (e.g., voice) TX. One key metric of WLAN receiver **413** performance is AGC which is used to regulate the received signal strength at the input of the ADC **472** such that the required signal-to-noise ratio ("SNR") for proper decoding is met. In the presence of strong ACI, better performance is obtained by reducing the level of AGC. This however has the effect of reducing WLAN receiver **413** sensitivity, that is, only WLAN frames with higher SNR values will be decoded correctly. This trade-off is not present in the absence of ACI and maintaining AGC at a high value is recommended for improved WLAN receiver **413** performance.

Now, Bluetooth transmits voice signals (for example) over session connection oriented ("SCO") duplex links. SCO activity is periodic and, in its most common version, occurs every 3.75 ms and lasts for 1.25 ms. 625 µs of the Bluetooth cycle is attributed to RX and the other 625 µs is attributed to TX. To correctly receive WLAN beacon/probe response frames (i.e., WLAN discovery frames) without having to deal with AGC (due to ACI), the entire WLAN frame must completely fall between Bluetooth TX activity (i.e., a period of 3.125 ms). Even though this duration is almost twice the length of a legacy WLAN beacon there are two problems. First, the probability of the WLAN discovery frames occurring at the beginning of this window is very small. Statistically, the beacon will occur at the midpoint only 50% of the time leaving only 1.56 ms to completely receive the WLAN discovery frames. Second, in an enterprise environment with multiple virtual local area networks ("VLANs") / service set identifiers ("SSIDs") per beacon, the WLAN beacon is significantly increased in size (e.g., as large as 10 ms) in addition to the continuously growing number of information elements tagged at the end of the WLAN beacon. Both of these factors imply that simultaneous Bluetooth TX and WLAN RX operation is required to support simultaneous Bluetooth voice and WLAN discovery operation. This requires reducing AGC. While the reduced sensitivity associated with reduced levels of AGC will be offset in dense enterprise wide WLAN deployments with high SNR values at the scanning clients, however, in residential single AP **490** deployments (for example), reducing the AGC may imply undetected APs **490** or lost links due to missed WLAN beacons.

For reference, an AP **490** in a WLAN **410** periodically sends a "beacon frame" to announce its presence and relay information, such as timestamp, SSID, and other parameters regarding the AP **490** to WLAN devices (e.g., **100, 411**) that are within range. WLAN devices **100, 411** continually scan all WLAN radio channels and listen to beacons as the basis for choosing which AP **490** is best to associate with. A WLAN device **100, 411** sends a "probe request frame" when it needs to obtain information from another device. For example, a WLAN device **100, 411** would send a probe request to determine which APs **490** are within range. And, a WLAN device (e.g., **100, 411, 490**) will respond with a "probe response frame", containing capability information, supported data rates, etc., after it receives a probe request frame.

The present application provides a dynamic AGC method that takes the environment and beacon duration into consideration before adjusting the level of AGC to be used.

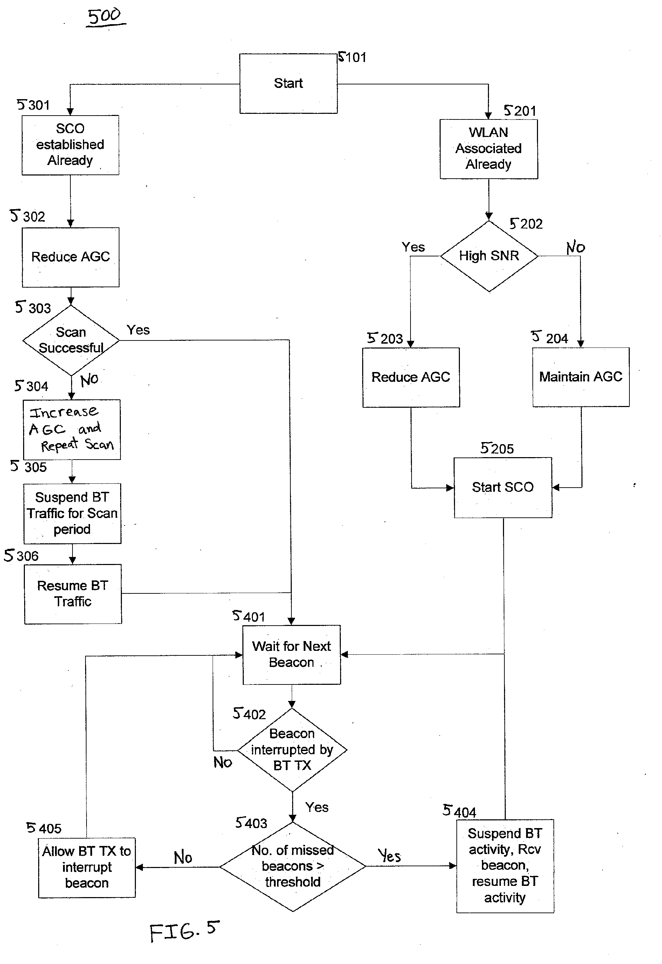

FIG. 5 is a flow chart illustrating operations **500** of modules **206** within the memory **200** of a wireless device **100** for adjusting automatic gain control in the WLAN receiver **411** of the wireless device **100** during simultaneous WLAN and Bluetooth communications, in accordance with an embodiment of the application.

At step **5101,** the operations **500** start. Two possible paths **5201, 5301** are available depending on which radio **411, 421** is already active. In the first path **5201,** the WLAN radio **411** is active. In the second path **5301,** the Bluetooth SCO session is active for the Bluetooth radio **421.**

At step **5201,** the WLAN radio **411** is already associated with, for example, an AP **490.**

At step **5202,** a determination is made as to the type of environment the WLAN radio **411** is operating in by measuring the SNR of received WLAN signals. The objective here is to determine if the WLAN SNR is high enough such that even if the AGC level is reduced, the beacons/probe responses (e.g., from APs **490**) can still be received.

At step **5203,** if the SNR is above a predetermined threshold (e.g., -65 dBm), the AGC level is reduced.

At step **5204,** if the SNR is below the predetermined threshold, the AGC level is maintained.

At step **5205,** the Bluetooth SCO session is started after the AGC has been adjusted at steps **5203** or **5204.** At the end of this step, both radios **411, 421** have active sessions and are operating in parallel or simultaneously. Operations of the WLAN radio **411** proceed to step **5401** where it continues to receive beacons as part of WLAN link maintenance.

At step **5301,** the Bluetooth radio's SCO session is already active.

At step **5302,** being conservative with respect to dropping Bluetooth packets, the AGC level is reduced. This improves the detection of WLAN beacons.

At step **5303,** a scan for APs **490** is performed by the WLAN radio **411.** The scan will be successful in an environment with strong WLAN SNR and, if so, operations proceed to step **5401.** In this case, the duration of the beacon does not affect the scan success probability since simultaneous Bluetooth TX and WLAN RX is possible.

At step **5304,** if the scan of step **5303** was not successful, then the only possibility remaining is the availability of an undetected AP **490** at a low received signal strength indication ("RSSI") value (e.g., -80 dBm). To rule out this possibility, the AGC level is increased to the normal level (e.g., its level before it was reduced at step **5302**) and the scan is repeated.

At step **5305,** noting that it is likely that the WLAN beacon/probe response will overlap the Bluetooth TX (i.e., the beacon/probe response will not be decoded correctly) or will actually occur during a Bluetooth TX in which case it will be missed completely, Bluetooth traffic is suspended for the duration of the one time scan of step **5304** (which should last on the order of approximately 1 inter-beacon arrive time times the number of scanned frequencies (e.g., 3 x 102.4 ms)) to prevent this from occurring. To prevent such a long audio outage, the scan interval may be spread over a longer period of time.

At step **5306,** Bluetooth traffic is resumed after the WLAN scan of step **5304** is completed. If an AP **490** is found or not, operations move to the link maintenance step **5401.** For reference, link maintenance refers to the need for an existing or newly established WLAN connection to continue receiving beacons to ensure connectivity to the AP **490** and prevent termination.

At step **5401,** operations wait until the next beacon. This branch of the operations **500** pertains to link maintenance. This branch only pertains to those cases where the AGC level was not reduced since simultaneous Bluetooth TX and WLAN RX is not possible.

At step **5402,** a determination is made as to whether the beacon/probe response is going to last longer than the beginning of the Bluetooth TX period. That is, whether the WLAN beacon is likely to be interrupted by a Bluetooth TX. This may be readily determined as Bluetooth TX activity is highly periodic (i.e., typically 3.75 ms between transmission periods). Typically, cases with low SNR values (i.e., requiring high AGC) correspond to a single AP **490** deployment with short beacons (e.g., residential deployments with no VLANs/SSIDs and a limited number of information elements). This implies that the probability of fully receiving a WLAN beacon/probe response in between Bluetooth TX activity is high. If the WLAN beacon is likely to be interrupted, operations proceed to step **5403.** If the WLAN beacon is not likely to be interrupted, operations return to step **5401.**

At step **5403,** a determination is made as to whether the number of missed beacons exceeds a threshold (e.g., 10). If the number of missed beacons exceeds the threshold, operations proceed to step **5404.** Otherwise, operations proceed to step **5405.**

At step **5404,** if multiple beacons/probes are missed, to prevent link termination due to missed beacons, Bluetooth TX activity is suspended until a beacon is received. When a beacon is received, operations proceed to step **5401.**

At step **5405,** if multiple beacons/probes are not missed, Bluetooth TX is allowed to interrupt the beacon and operations proceed to step **5401.** This will also address the event where the beacons begin during a Bluetooth TX (i.e., step **5404**).

Thus, to reiterate, according to one embodiment of the application there is provided a method for adjusting a gain level for a receiver **413** of a first radio (e.g., a wireless local area network ("WLAN") radio) **411** simultaneously operational with a transmitter **423** of a second radio (e.g., a Bluetooth radio) **421,** comprising: determining a signal-to-noise ratio ("SNR") value for signals (e.g., WLAN signals) received by the receiver **413** from an access point ("AP") **490;** and, when the first radio **411** is associated with the AP **490** and the transmitter **423** is not transmitting, if the SNR value exceeds a SNR threshold, reducing the gain level for the receiver **413** from an initial level and initiating transmission from the transmitter **423,** otherwise maintaining the gain level for the receiver **413** at the initial level and initiating transmission from the transmitter **423;** wherein the SNR threshold is a SNR value above which beacon signals (e.g., WLAN beacon signals) from the AP **490** can be successfully received by the receiver **413.**

The above method may further include, when the first radio **411** is not associated with the AP **490** and the transmitter **423** is transmitting, reducing the gain level for the receiver **413** from the initial level and scanning for the beacon signals from the AP **490** and, if the scanning is not successful, increasing the gain level to the initial level, suspending transmission from the transmitter **423,** re-scanning for the beacon signals from the AP **490,** and resuming transmission from the transmitter **423.** The method may further include, when the first radio **411** is associated with the AP **490** and the transmitter **423** is transmitting, determining a number of missed beacon signals (e.g., a number of missed WLAN beacon signals) and, if the number of missed beacon signals exceeds a missed beacon signals threshold (e.g., a missed WLAN beacon signals threshold), suspending transmission from the transmitter **423,** scanning for the beacon signals from the AP **490,** receiving a beacon signal (e.g., a WLAN beacon signal) from the AP **490,** and resuming transmission from the transmitter **423.** The transmission from the transmitter **423** may be suspended for one scan period. The re-scanning may be for one scan period. The gain level may be an automatic gain control ("AGC") level. The first radio **411** and the second radio **421** may be deployed in a single wireless device **100.** The signals (e.g., WLAN signals) may be beacon signals (e.g., WLAN beacon signals). The beacon signals (e.g., WLAN beacon signals) may include probe response signals (e.g., WLAN probe response signals). The SNR threshold may be -65 dBm and the missed beacon signals threshold (e.g., the missed WLAN beacon signals threshold) may be 10. And, the first radio **411** may be a wireless local area network ("WLAN") radio, the second radio **421** may be a Bluetooth radio, the signals may be WLAN signals, and the beacon signals may be WLAN beacon signals.

The above embodiments may contribute to an improved method and system for adjusting automatic gain control in the WLAN receiver **413** of a wireless device **100** during simultaneous WLAN and Bluetooth communications and may provide one or more advantages. For example, the use of the WLAN SNR to adjust the level of AGC within the WLAN receiver **413** allows for more efficient use of both the WLAN and Bluetooth radios **411, 421.**

The above described method is generally performed by a wireless device **100.** However, according to one example embodiment, the method can be performed by any other data processing system **100** such as a personal computer ("PC"), server, laptop computer, etc.

While example embodiments of this application are primarily discussed as a method, a person of ordinary skill in the art will understand that the apparatus discussed above with reference to a wireless device **100** and a data processing system, may be programmed to enable the practice of the method of these example embodiments. Moreover, an article of manufacture or product for use with a wireless device **100** or data processing system, such as a pre-recorded storage device or other similar computer readable medium or product including program instructions recorded thereon, may direct the wireless device **100** or data processing system to facilitate the practice of the method of these example embodiments. It is understood that such apparatus, products, and articles of manufacture also come within the scope of the application.

The embodiments of the application described above are intended to be exemplary only. Those skilled in this art will understand that various modifications of detail may be made to these embodiments, all of which come within the scope of the application.

## Claims

1. A method for adjusting a gain level for a receiver (413) of a first radio (411) simultaneously operational with a transmitter (423) of a second radio (421), the first radio (411) and the second radio (413) being deployed in a single wireless device (100), comprising:
determining a signal-to-noise ratio ("SNR") value for signals received by the receiver (413) from an access point ("AP") (490); and,
when the first radio (411) is associated with the AP (490) and the transmitter (423) is not transmitting, if the SNR value exceeds a SNR threshold, reducing the gain level for the receiver (413) from an initial level and initiating transmission from the transmitter (423), otherwise maintaining the gain level for the receiver (413) at the initial level and initiating transmission from the transmitter (423);
wherein the SNR threshold is a SNR value above which beacon signals from the AP (490) can be successfully received by the receiver (413).

2. The method of claim 1 and further comprising, when the first radio (411) is not associated with the AP (490) and the transmitter (423) is transmitting, reducing the gain level for the receiver (413) from the initial level and scanning for the beacon signals from the AP (490) and, if the scanning is not successful, increasing the gain level to the initial level, suspending transmission from the transmitter (423), re-scanning for the beacon signals from the AP (490), and resuming transmission from the transmitter (423).

3. The method of claim 1 or claim 2 and further comprising, when the first radio (411) is associated with the AP (490) and the transmitter (423) is transmitting, determining a number of missed beacon signals and, if the number of missed beacon signals exceeds a missed beacon signals threshold, suspending transmission from the transmitter (423), scanning for the beacon signals from the AP (490), receiving a beacon signal from the AP (490), and resuming transmission from the transmitter (423).

4. The method of claim 2 wherein the transmission from the transmitter (423) is suspended for one scan period.

5. The method of claim 2 or claim 4 wherein the re-scanning is for one scan period.

6. The method of any one of claims 1 to 5 wherein the gain level is an automatic gain control ("AGC") level.

7. The method of any one of claims 1 to 6 wherein the signals are beacon signals.

8. The method of any one of claims 1 to 7 wherein the beacon signals include probe response signals.

9. The method of any one of claims 3 to 8 wherein the SNR threshold is -65 dBm and the missed beacon signals threshold is 10.

10. The method of any one of claims 1 to 9 wherein the first radio (411) is a wireless local area network ("WLAN") radio, wherein the second radio (413) is a Bluetooth radio, wherein the signals are WLAN signals, and wherein the beacon signals are WLAN beacon signals.

11. A system (100) for adjusting a gain level for a receiver (413) of a first radio (411) simultaneously operational with a transmitter (423) of a second radio (413), comprising:
a processor (138) coupled to memory (200); and,
at least one of hardware and software modules (206) within the memory (200) and controlled or executed by the processor (138) for causing the system (100) to implement the method of any one of claims 1 to 10.

12. The system (100) of claim 11 wherein the system (100) is, or is included in, the single wireless device (100).

## Patentansprüche

1. Verfahren zum Anpassen eines Verstärkungspegels für einen Empfänger (413) einer ersten Funkvorrichtung (411), gleichzeitig betreibbar mit einem Sender (423) einer zweiten Funkvorrichtung (421), wobei die erste Funkvorrichtung (411) und die zweite Funkvorrichtung (421) in einer einzelnen Drahtlosvorrichtung eingesetzt werden, umfassend:
Bestimmen eines Signal-Rausch-Verhältnis ("SNR") Wertes für Signale, die durch den Empfänger (413) von einem Zugriffspunkt ("AP") empfangen wurden; und,
wenn die erste Funkvorrichtung (411) mit dem AP (490) verbunden ist und der Sender (423) nicht sendet, falls der SNR Wert einen SNR Grenzwert überschreitet, Verringern des Verstärkungspegels für den Empfänger (413) von einem Anfangspegel und Einleiten der Übertragung von dem Sender (423), andernfalls Beibehalten des Verstärkungspegels für den Empfänger (413) auf dem Anfangspegel und Einleiten der Übertragung von dem Sender (423);
wobei der SNR Grenzwert ein SNR Wert ist, über dem Bakensignale von dem AP (490) durch den Empfänger (413) erfolgreich empfangen werden können.

2. Verfahren nach Anspruch 1 und ferner umfassend, wenn die erste Funkvorrichtung (411) nicht mit dem AP (490) verbunden ist und der Sender (423) sendet, Verringern des Verstärkungspegels für den Empfänger (413) von dem Anfangspegel und Abtasten nach den Bakensignalen von dem AP (490) und, falls das Abtasten nicht erfolgreich ist, Erhöhen des Verstärkungspegels auf den Anfangspegel, Aussetzen der Übertragung von dem Sender (423), erneutes Abtasten nach den Bakensignalen von dem AP (490), und Wiederaufnehmen der Übertragung von dem Sender (423).

3. Verfahren nach Anspruch 1 oder 2 und ferner umfassend, wenn die erste Funkvorrichtung (411) mit dem AP (490) verbunden ist und der Sender (423) sendet, Bestimmen einer Anzahl von verfehlten Bakensignalen und, falls die Anzahl von verfehlten Bakensignalen einen Grenzwert für verfehlte Bakensignale überschreitet, Aussetzen der Übertragung von dem Sender (423), Abtasten nach den Bakensignalen von dem AP (490), Empfangen eines Bakensignals von dem AP (490), und Fortsetzen der Übertragung von dem Sender (423).

4. Verfahren nach Anspruch 2, wobei die Sendung von dem Sender (423) für eine Abtastperiode ausgesetzt wird.

5. Verfahren nach Anspruch 2 oder Anspruch 4, wobei das erneute Abtasten für eine Abtastperiode ist.

6. Verfahren nach einem der Ansprüche 1 bis 5, wobei der Verstärkungspegel ein automatischer Verstärkungssteuerpegel ("AGC") ist.

7. Verfahren nach einem der Ansprüche 1 bis 6, wobei die Signale Bakensignale sind.

8. Verfahren nach einem der Ansprüche 1 bis 7, wobei die Bakensignale Testantwortsignale beinhalten.

9. Verfahren nach einem der Ansprüche 3 bis 8, wobei der SNR Grenzwert -65 dBm ist und der Grenzwert von verfehlten Bakensignalen 10 ist.

10. Verfahren nach einem der Ansprüche 1 bis 9, wobei die erste Funkvorrichtung (411) eine lokale Drahtlosnetzwerk ("WLAN") Funkvorrichtung ist, wobei die zweite Funkvorrichtung (413) eine Bluetooth-Funkvorrichtung ist, wobei die Signale WLAN-Signale sind, und wobei die Bakensignale WLAN-Bakensignale sind.

11. System (100) zum Anpassen eines Verstärkungspegels für einen Empfänger (413) einer ersten Funkvorrichtung (411), gleichzeitig betreibbar mit einem Sender (423) einer zweiten Funkvorrichtung (421), aufweisend:
einen mit einem Speicher (200) gekoppelten Prozessor (138); und,
Hardware- und/oder Softwaremodule (206) in dem Speicher (200) und gesteuert oder ausgeführt durch den Prozessor (138) um das System (100) zu veranlassen, das Verfahren nach einem der Ansprüche 1 bis 10 durchzuführen.

12. System nach Anspruch 11, wobei das System (100) die einzelne Drahtlosvorrichtung (100) ist oder darin beinhaltet ist.

## Revendications

1. Procédé pour régler un niveau de gain pour un récepteur (413) d'une première radio (411) fonctionnant simultanément avec un émetteur (423) d'une deuxième radio (421), la première radio (411) et la deuxième radio (413) étant déployées dans un dispositif sans fil unique (100), comprenant le fait :
de déterminer une valeur de rapport signal-sur-bruit ("SNR") pour des signaux reçus par le récepteur (413) à partir d'un point d'accès ("AP") (490) ; et,
lorsque la première radio (411) est associée à l'AP (490) et l'émetteur (423) ne transmet pas, si la valeur SNR est supérieure à un seuil SNR, de réduire le niveau de gain pour le récepteur (413) à partir d'un niveau initial et d'initier la transmission à partir de l'émetteur (423), sinon de maintenir le niveau de gain pour le récepteur (413) au niveau initial et d'initier la transmission à partir de l'émetteur (423) ;
dans lequel le seuil SNR est une valeur SNR au-dessus de laquelle des signaux de balise provenant de l'AP (490) peuvent être reçus avec succès par le récepteur (413).

2. Procédé de la revendication 1 et comprenant en outre, lorsque la première radio (411) n'est pas associée à l'AP (490) et l'émetteur (423) transmet, la réduction du niveau de gain pour le récepteur (413) à partir du niveau initial et le balayage pour les signaux de balise provenant de l'AP (490) et, si le balayage n'est pas réussi, l'augmentation du niveau de gain au niveau initial, la suspension de la transmission à partir de l'émetteur (423), le re-balayage pour les signaux de balise provenant de l'AP (490) et la reprise de la transmission à partir de l'émetteur (423).

3. Procédé de la revendication 1 ou 2 et comprenant en outre, lorsque la première radio (411) est associée à l'AP (490) et l'émetteur (423) transmet, la détermination d'un nombre de signaux de balise manqués et, si le nombre de signaux de balise manqués est supérieur à un seuil de signaux de balise manqués, la suspension de la transmission à partir de l'émetteur (423), le balayage pour les signaux de balise provenant de l'AP (490), la réception d'un signal de balise provenant de l'AP (490) et la reprise de la transmission à partir de l'émetteur (423).

4. Procédé de la revendication 2, dans lequel la transmission à partir de l'émetteur (423) est suspendue pendant une période de balayage.

5. Procédé de la revendication 2 ou 4, dans lequel le re-balayage est pour une période de balayage.

6. Procédé de l'une quelconque des revendications 1 à 5, dans lequel le niveau de gain est un niveau de commande de gain automatique ("AGC").

7. Procédé de l'une quelconque des revendications 1 à 6, dans lequel les signaux sont des signaux de balise.

8. Procédé de l'une quelconque des revendications 1 à 7, dans lequel les signaux de balise comportent des signaux de réponse de sonde.

9. Procédé de l'une quelconque des revendications 3 à 8, dans lequel le seuil SNR est égal à -65 dBm et le seuil de signaux de balise manqués est égal à 10.

10. Procédé de l'une quelconque des revendications 1 à 9, dans lequel la première radio (411) est une radio de réseau local sans fil ("WLAN"), où la deuxième radio (413) est une radio Bluetooth, où les signaux sont des signaux WLAN, et où les signaux de balise sont des signaux de balise WLAN.

11. Système (100) pour régler un niveau de gain pour un récepteur (413) d'une première radio (411) fonctionnant simultanément avec un émetteur (423) d'une deuxième radio (413), comprenant :
un processeur (138) couplé à une mémoire (200) ; et,
au moins un des modules matériels et logiciels (206) dans la mémoire (200) et commandés ou exécutés par le processeur (138) pour amener le système (100) à mettre en oeuvre le procédé de l'une quelconque des revendications 1 à 10.

12. Système (100) de la revendication 11, dans lequel le système (100) est le dispositif sans fil unique (100) ou est inclus dans celui-ci.
